# EUROPÄISCHE PATENTSCHRIFT

(11) **EP 0 832 548 B1**
(45) Veröffentlichungstag und Bekanntmachung des Hinweises auf die Patenterteilung: **12.05.1999**
(21) Anmeldenummer: 95928945.5
(22) Anmeldetag: 16.08.1995
(51) Int. Cl.: H05K 7/14

(54) **FRONTSYSTEM EINER FLACHBAUGRUPPE MIT INTEGRIERTEM TASTENELEMENT FÜR EINE AKTIV-PASSIV-SCHALTUNG**
FRONT PANEL SYSTEM FOR A PRINTED CIRCUIT CARD WITH AN INTEGRATED KEY ELEMENT FOR ACTIVE/PASSIVE SWITCHING
SYSTEME DE PANNEAU AVANT D'UNE CARTE A CIRCUITS IMPRIMES POURVU D'UN ELEMENT INTEGRE A TOUCHE DE COMMUTATION ACTIVE/PASSIVE

(30) Priorität: 12.06.1995 DE 29509602 U
(43) Veröffentlichungstag der Anmeldung: 01.04.1998
(73) Patentinhaber: SIEMENS AKTIENGESELLSCHAFT, 80333 München (DE)
(72) Erfinder: BILLENSTEIN, Ernst, D-91593 Burgbernheim (DE); KÖRBER, Werner, D-91282 Betzenstein (DE); KURRER, Siegfried, D-90449 Nürnberg (DE); SCHAFFER, Kurt-Michael, D-90542 Eckental (DE)
(86) Internationale Anmeldenummer: DE9501078
(87) Internationale Veröffentlichungsnummer: WO9642186

(56) Entgegenhaltungen:
- EP-A- 0 369 025
- EP-A- 0 579 859
- DE-A- 4 105 948

## Beschreibung

Aus der EP 0 304 772 B1 ist ein Frontstecksystem mit einer nacheilenden Endkontaktvorrichtung bekannt. Dabei ist ein Frontsteckverbinder auf ein an der Stirnseite einer Flachbaugruppe befindliches Frontelement aufsteckbar. Dies erfolgt mittels einer Drehbewegung, indem der Frontsteckverbinder in ein Drehlager an einem Ende des Frontelementes einhängbar ist. Am anderen Ende von Frontelement und Frontsteckverbinder befindet sich eine Endkontaktvorrichtung, welche erst dann in Eingriff kommt, nachdem aufgrund einer Bedienung einer Verschlußvorrichtung der Frontsteckverbinder vollständig auf dem Frontelement aufgesteckt ist. Als Verschlußvorrichtung dient bevorzugt eine ebenfalls in das andere Ende des Frontsteckverbinders eingesetzte Schraube, so daß die Arbeitskontakte der Endkontaktvorrichtung erst dann in Eingriff kommen, wenn die Schraube vollständig in ein gegenüber im Frontelement befindliches Gewinde eingeschraubt ist und hiermit das vollständige Aufstecken des Frontelementes bewirkt wurde. Hiermit kann sichergestellt werden, daß die über das Frontelement und den Frontsteckverbinder geleiteten elektrischen Signale gleichzeitig erst dann freigegeben werden, wenn alle Kontakte zwischen Frontelement und Frontsteckverbinder geschlossen sind, bzw. der gestoppt wird, bevor einer der Kontakte beim Abschwenken des Frontsteckverbinders unterbrochen wird.

Es ist zum Teil notwendig, auch bei Flachbaugruppen, welche mittels einer z.B. aus der EP 0 194 515 B1 bekannten Steck- und Ziehhilfe in den Steckplatz eines Baugruppenträgers eingehebelt bzw. ausgehoben werden können, eine geordnete Freigabe bzw. Unterbrechung des gesamten Signalaustausches über deren rückseitigen Steckverbinder zu einer Rückwandleiterplatte des Baugruppenträgers und einem dort befindlichen Datenbus zu bewirken. So soll z.B. zu Beginn der Aushebelung einer Flachbaugruppe eine komplette Unterbrechung von deren Signalaustausch bewirkt werden können, bevor einer der Kontakte zwischen Steckverbinder und Rückwandleiterplatte getrennt wird, während andere Kontakte noch nicht unterbrochen sind.

Zur Lösung dieses Problems wird in der Druckschrift Honeywell Outline, Sensorik und Automation, Jahrgang 9, Heft 1, Seiten 10, 12 in dem Artikel Leiterplattenausbau ohne Systemunterbrechung mit Honeywell Schaltern und Sensoren" vorgeschlagen, an der Kante einer Leiterplatte entweder auf deren Ober- oder Unterseite z.B. einen Schalter anzubringen und über entsprechende Leiterbahnen z.B. mit der Hauptstromversorgung zu verbinden. Auf den Schalter wirkt ein Verriegelungsmechanismus ein, welcher die Leiterplatte in ihrer Position im Baugruppenträger fixiert. Im verriegelten Zustand liegt der Riegel des Verriegelungsmechanismus an der den Schalter tragenden Kante der Leiterplatte an und bewirkt eine Betätigung des Schalters und somit eine elektrische Aktivierung der Leiterplatte. Wird dagegen der Riegel von der Kante abgeschwenkt, so wird der Schalter unterbrochen und die Leiterplatte elektrisch inaktiv geschaltet. An Stelle des Schalters kann auch ein Infrarotbauteil eingesetzt werden.

Ein wesentliches Problem dieser Vorrichtung wird darin gesehen, daß eine präzise Positionierung des Schalters am Leiterplattenrand außerordentlich schwierig ist. Wird der Schalter z.B. mit entsprechenden Leiterbahnen auf der Leiterplattenoberfläche verlötet, so ist es bedingt durch den Lötprozeß nur sehr schwer möglich sicherzustellen, daß der Schalthebel insbesondere eines Miniaturschalters so genau plaziert werden kann, daß dieser bei Anliegen des Riegels an der Kante der Leiterplatte ordnungsgemäß betätigt wird.

Der Erfindung liegt somit die Aufgabe zugrunde ein Frontsystem für eine Flachbaugruppe anzugeben, welches in einer präzisen und dauerhaften Weise mit einer elektrischen Aktiv-Passiv-Schaltung für die Leiterplatte versehen ist.

Die Aufgabe wird gelöst mit der im Anspruch 1 angegebenen Vorrichtung. Weitere, vorteilhafte Ausführungsformen der Erfindung sind in den Unteransprüchen angegeben.

Die Erfindung wird mit den in den nachfolgend kurz angeführten Figuren dargestellten Beispielen weiter erläutert. Dabei zeigt
- Fig.1.: eine perspektivische Seitenansicht auf die untere Querschiene eines Baugruppenträgers und ein beispielhaftes, gemäß der Erfindung gestaltetes unteres Endstück für die Frontplatte einer Leiterplatte mit Hebelziehgriff, und
- Fig.2.: eine perspektivische Seitenansicht auf einen Hebelziehgriff für das beispielhafte Frontsystem von Figur 1.

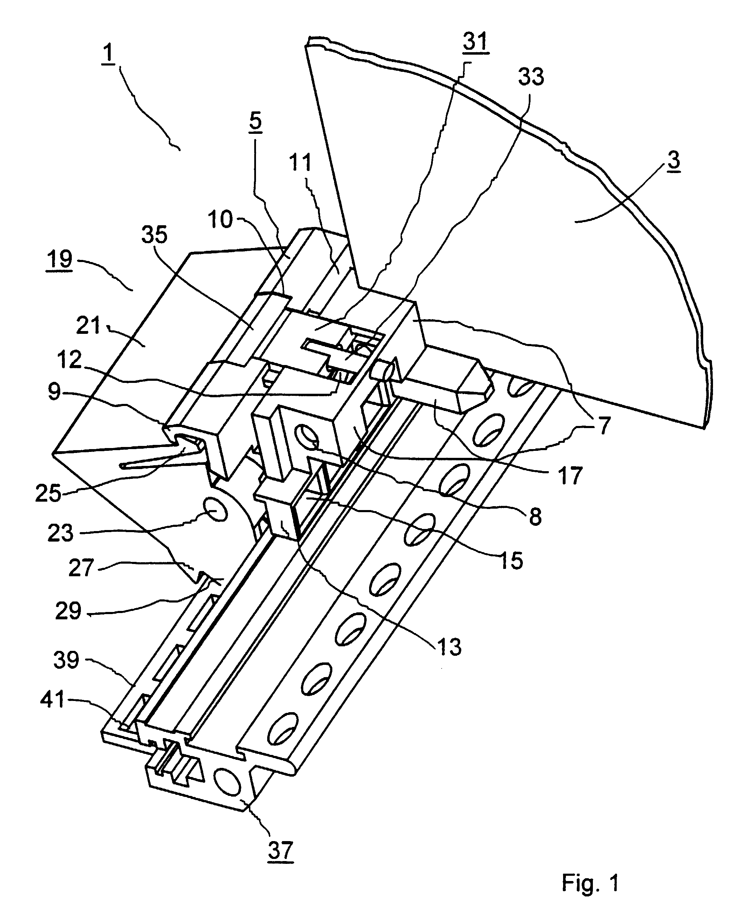

Figur 1 zeigt in einer perspektivischen Seitenansicht ausschnittsweise den unteren, vorderen Eckbereich 1 eines gemäß der Erfindung gestalteten Frontsystems einer Flachbaugrupppe 3. Der untere Eckbereich ruht dabei auf der unteren Querschiene 37 eines Baugruppenträgers und weist dabei als Hauptkomponenten einen unterer Hebelziehgriff 19, ein unteres Endstück 5 und eine aus Gründen der Übersichtlichkeit nicht dargestellte Frontplatte auf. Dem unteren Endstück 5 kommt dabei eine zentrale Haltefunktion zu, da es zum einen als Träger für den insbesondere über einen Bohrungszapfen 23 drehbar gelagerten Hebelziehgriff 19 dient. Andererseits kann es auch zur Halterung des unteren Endes einer Frontplatte dienen, welche hierzu vorteilhaft in eine Nut 11 eingeschoben und über eine in eine Bohrung 12 eingreifende Schraube gehalten wird. Die Verbindung zwischen dem unteren Endstück 5 und der vorderen, unteren Ecke der Flachbaugruppe erfolgt bevorzugt über einen Halteblock 7 und mittels einer in eine Bohrung 8 desselben eingreifenden Schraube.

Schließlich können weitere Komponenten am Endstück angebracht sein. So enthält das in Figur 1 dargestellte Endstück einen Kodierblock 13, in den Kodierkammern zum Einsetzen von Kodierstiften eingebracht sind. Diese können auf gegenüberliegend am unteren Querträger 37 angebrachten Kodierkammern eingreifen, welche mit komplementär kodierten Kodierstiften bestückt sind. Hiermit kann sichergestellt werden, daß nur eine bestimmte, ausgewählte Flachbaugruppe in einem Steckplatz eines Baugruppenträgers positionierbar ist. Schließlich ist noch ein Führungsstift 17 vorhanden, welcher nach Eingriff in eine gegenüberliegende Führungsbohrung ein verkantfreies, ordnungsgemäßes Einschieben der Flachbaugruppe gewährleistet.

Zum Ein- bzw. Aushebeln der Flachbaugruppe 3 in den bzw. aus dem entsprechenden Steckplatz dient ein unterer Hebelziehgriff 19, welcher durch Betätigung des Griffteils 21 bedient werden kann. Beim Aushebeln muß der Griff nach unten gedrückt werden, so daß sich mindestens eine auf der Unterseite vorspringende Aushebelnase 27 an einer Stirnkante 39 der unteren Querschiene 37 abstützen kann. Umgekehrt muß beim Einhebeln der Griff nach oben gedrückt werden, so daß sich mindestens eine ebenfalls auf der Unterseite vorspringende Einhebelkante 29 im Inneren von ebenfalls im Bereich der Stirnkante 39 der unteren Querschiene 37 befindliche mindestens eine Eingriffsmulde 41 abstützen kann. Üblicherweise sind am Endstück 5 noch Mittel vorhanden, über die der Hebelziehgriff 19 bei Erreichen des in den Baugruppenträger vollständig eingeschobenen Zustands der Flachbaugruppe 3 in der entsprechenden Position fixiert wird. Dieser Zustand ist in Figur 1 dargestellt.

Vorteilhaft weist der Hebelziehgriff 19 hierzu auf seiner Oberseite eine auf das Endstück 5 gerichtete, federnde und nach oben stehende Rastnase 25 auf, welche eine auf den Hebelziehgriff 19 gerichtete und nach unten abgehende Rastkante 9 am unteren Endstück 5 hintergreift.

In der gleichen Weise ist auch an dem in Figur 1 nicht dargestellten vorderen, oberen Eckbereich der Flachbaugruppe eine entsprechende Anordnung aus einem oberen Endstück mit einem daran drehbar gelagerten oberen Hebelziehgriff angebracht. Dieser greift dann zum Ein- und Aushebeln in eine entsprechende obere Querschiene eines Baugruppenträgers ein.

Erfindungsgemäß ist nun im unteren oder oberen Endstück ein mechanisches Tastenelement integriert, auf welches über den entsprechenden Hebelziehgriff bei Vorliegen von dessen fixierter Position derart eingegriffen wird, daß hiermit ein externes elektrisches Schaltelement aktivierbar ist. Es ist hiermit möglich, die Flachbaugruppe elektrische freizuschalten, z.B. durch Aktivierung von deren Stromversorgung. Umgekehrt kann die Flachbaugruppe elektrisch passiv geschaltet werden, in dem im Moment einer Aushebelung der Flachbaugruppe der Eingriff des Hebelziehgriffes auf das in das Endstück integrierte Tastenelement und damit auf das externe elektrische Schaltelement endet, und durch diese Freigabe des Schaltelements z.B. die elektrische Stromversorgung der Flachbaugruppe wieder passiviert wird.

In Figur 1 ist beispielhaft ein gemäß der Erfindung in das untere Eckstück 5 integriertes mechanisches Tastenelement 31 dargestellt. Dieses ist bevorzugt in einem bis in den Bereich der Rastkante 9 des Endstückes 5 reichenden Aufnahmeschlitz bzw. einer Ausbruchöffnung 10 gelagert. An einer der Flachbaugruppe zugewandten Rückseite des Endstücks 5 ragt das Tastenelement so über das Endstück hinaus, daß hierüber ein aus Gründen der Übersichtlichkeit in Figur 1 nicht dargestelltes, externes Schaltelement aktivier- oder passivierbar ist. Das mechanische Tastenelement wird bei Erreichen des fixierten Zustandes des Hebelziehgriffes 19 durch dessen auftreffende Hinterseite betätigt. Gemäß einer Ausführung kann diese Betätigung z.B. durch eine dem unteren Endstück 5 zugewandte Stirnseite einer in Figur 1 dargestellten Rastnase 25 des Hebelziehgriffes erfolgen, welche auch als eine Verrastfeder mit nach oben stehender Rastnase bezeichnet werden kann. Bei einer anderen, bereits im Beispiel der Figur 1 dargestellten Ausführungsform weist der Hebelziehgriff 19 bevorzugt auf dessen Oberseite ein vorstehendes Druckstück 35 auf, welches bei Annäherung des Hebelziehgriffes 19 an dessen fixierte Position auf das mechanische Tastenelement 31 eingreift.

Vorteilhaft ist das mechanische Tastenelement in Form eines im Endstück gelagerten Schiebers 31 ausgeführt. Eine derartige Ausführung ist im Beispiel der Figur 1 bereits dargestellt. Gemäß einer weiteren, ebenfalls bereits dargestellten Ausführung ist an das Tastenelement 31 ein verlangernder Kontaktbolzen 33 angebracht, womit über eine der Flachbaugruppe 3 zugewandten Außenseite des Endstücks 5 hinaus auf ein entfernter angeordnetes Schaltelement eingegriffen werden kann. Schließlich sind vorteilhaft noch insbesondere auf den Schieber 31 des Tastenelementes einwirkende Federmittel vorhanden. Diese wirken auf das Tastenelement derart ein, daß dieses in einer dem Hebelziehgriff 19 zugewandten Ruheposition gehalten wird, solange sich der Hebelziehgriff nicht in der fixierten Position befindet. Dies ist insbesondere dann der Fall, wenn der Hebelziehgriff wegen des nicht vollständig in einen Baugruppenträger eingeschobenen Zustands der Flachbaugruppe noch teilweise an seiner Drehachse 23 beweglich ist, da die nach oben stehende Rastnase der Verrastfeder 25 nicht in die nach unten stehende Rastkante 9 des Endstücks 5 eingegriffen hat. Wird dagegen der Hebelziehgriff in die fixierte Position gebracht, d.h. die Verrastfeder 25 mit der Rastkante 9 in Eingriff gebracht und der in Figur 1 dargestellte Zustand erreicht, so wird das Tastenelement in Richtung auf die Flachbaugruppe bewegt und es ist ein externes Schaltelement aktivierbar. Ist gemäß der Darstellung von Figur 1 ein den Schieber 31 verlangernder Kontaktbolzen 33 vorhanden, so können diese Federmittel in Form einer um den Kontaktbolzen gelegten Spiralfeder ausgeführt sein. Die "Rückstellkraft" zur Rückführung des Tastenelementes dessen passive Ruheposition kann auch vom externen Schaltelement selbst ausgeübt werden.

Die erfindungsgemäße Ausführung des Frontsystems hat den besonderen Vorteil, daß an die Gestaltung des exteren Schaltelements selbst, insbesondere dessen äußere Abmessungen, keine besonderen Anforderungen gestellt werden müssen. Vielmehr sind wegen der Übertragung des Schaltweges vom Hebelziehgriff über das erfindungsgemäß in das Eckstück integrierte Tastenelement unterschiedlichste Schaltelemente in verschiedenen Positionen einsetzbar. So kann beispielsweise das vom mechanischen Tastenelement aktivierte externe Schaltelement z.B. mittels Verklebung auf einer Außenseite des Endstücks 5 aufgesetzt sein. In diesem Fall ist es vorteilhaft über eine an Anschlußkontakten anbringbare Kabel- oder Kabelsteckverbindung mit der Flachbaugruppe 3 elektrisch verbindbar. Bei einer anderen Ausführungsform kann das vom mechanischen Tastenelement aktivierbare externe elektrische Schaltelement auch direkt auf einer Oberseite der Flachbaugruppe 3 angebracht sein. Auch in diesem Fall wirkt das integrierte Tastenelement quasi zur Übertragung des Schaltwegs zwischen Hebelziehgriff und elektrischem Schaltelement.

Die erfindungsgemäße Ausführung für eine Aktiv-Passiv-Schaltung für in einen Baugruppenträger einschiebbare Flachbaugruppen hat den Vorteil, daß das Tastenelement 31 durch dessen Integration in ein unteres oder oberes Endstück des Frontsystems einer Flachbaugruppe sehr exakt in eine genau definierbare Position gebracht werden kann. Es ist somit auch dann möglich, ein externes elektrisches Schaltelement dauerhaft sicher und verschleißfrei über den Hebelziehgriff zu betätigen, wenn die Schaltmittel des Schaltelementes nur einen sehr geringen Schaltweg aufweisen und das Schaltelement eine nicht zur Integration in oder zur Annäherung an das Endstück geeignete äußere Form oder elektrische, magnetische oder optische Wirkungsweise aufweist.

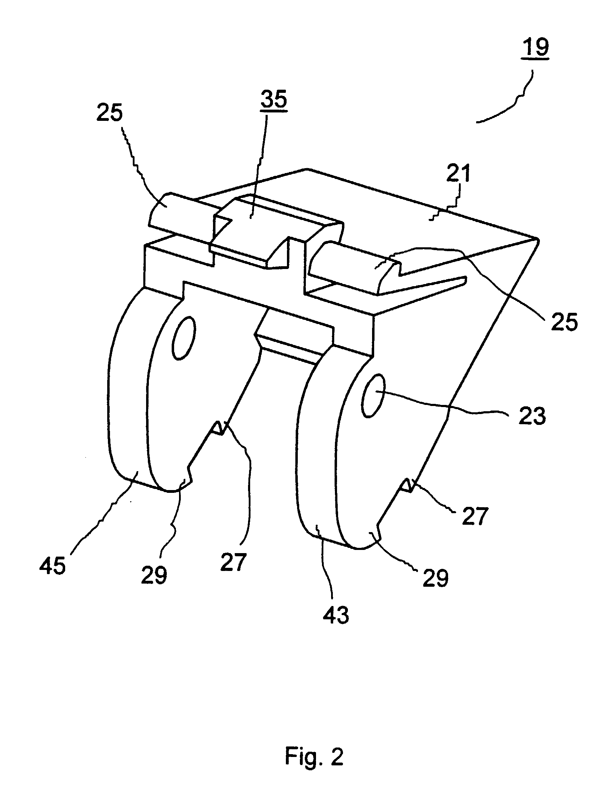

Figur 2 zeigt schließlich die perspektivische Seitenansicht einer bevorzugten Ausführungsform eines Hebelziehgriffs 19 für das erfindungsgemäße Frontsystem. Das Griffteil 21 wird dabei getragen von zwei Abstützschenkeln 43, 45, welche über je eine Bohrung zur Einführung mindestens eines Haltezapfens drehbar an einem unteren oder oberen Endstück lagerbar sind. Jeder der beiden Abstützschenkel verfügt dabei auf seiner Unterseite über eine Aushebelnase 27 und eine Einhebelkante 29, worüber die Aus- bzw. Einhebelung der dazugehörigen Flachbaugruppe in den entsprechenden Steckplatz des Baugruppentragers in der oben beschriebenen Weise bewerkstelligt werden kann. Auf der Oberseite des Hebelziehgriffs entspringt vom Griffteil 21 mindestens eine Verrastfeder 25, worüber der Hebelziehgriff durch Verklemmung mit der Rastkante 9 des Endstücks 5 fixierbar ist. Bei der in Figur 2 dargestellten, vorteilhaften Ausführungsform der Erfindung sind zwei Verrastfedern 25 an den Außenseiten des Hebelziehgriffes angeordnet, welche ein dazwischen auf der Oberseite des Griffteils 21 angeordnetes, in Richtung auf das Endstück vorstehendes Druckstück 35 flankieren. Die Stirnseite des Druckstücks 35 greift bei Annäherung des Hebelziehgriffs 19 an dessen fixierte Position auf das mechanische Tastenelement ein.

Diese Ausführung eines Hebelziehgriff 19 zeichnet- sich durch eine besonders günstige Symmetrie aus. Es können somit leicht und dauerhaft sowohl die zum Ein- und Aushebeln einer Flachbaugruppe benötigten Kräfte vom Griffteil 21 in die Abstützschenkel 43,45 übertragen werden, als auch durch das mittige Druckstück 35 ohne verkantende Querkraftanteile eine zentrische Schaltkraft für das externe elektrische Schaltelement direkt auf das in das Endstück integrierte Tastenelement eingeleitet werden.

## Patentansprüche

1. Frontsystem einer Flachbaugruppe (3), welche in einen Baugruppenträger einschiebbar ist, mit
a) je einem im oberen bzw. unteren vorderen Eckbereich (1) der Flachbaugruppe (3) angebrachten oberen bzw. unteren Endstück (5),
b) je einem am oberen bzw. unteren Endstück (5) angebrachten oberen bzw. unteren Hebelziehgriff (19) zum Ein- und Aushebeln der Flachbaugruppe (3) in und aus dem Baugruppenträger, welche Mittel (25) aufweisen, über die der jeweilige Hebelziehgriff (19) bei Erreichen des in den Baugruppenträger eingeschobenen Zustands der Flachbaugruppe (3) in der entsprechenden Position fixiert wird, und mit
c) einem im oberen oder unteren Endstück (5) integrierten mechanischen Tastenelement (31,33), auf das über den entsprechenden Hebelziehgriff (19) bei Erreichen von dessen fixierter Position derart eingegriffen wird, daß über das Tastenelement ein externes, elektrisches Schaltelement aktivierbar ist.

2. Frontsystem nach Anspruch 1, wobei Federmittel auf das mechanische Tastenelement (31,33) derart einwirken, daß dieses in einer dem Hebelziehgriff (19) zugewandten Ruheposition gehalten wird, solange sich der Hebelziehgriff (19) nicht in der fixierten Position befindet.

3. Frontsystem nach Anspruch 1 oder 2, wobei das mechanische Tastenelement in Form eines im Endstück (5) geführten Schiebers (31) ausgeführt ist.

4. Frontsystem nach einem der vorangegangenen Ansprüche, wobei an das mechanische Tastenelement ein verlangernder Kontaktbolzen (33) angebracht ist, womit über eine der Flachbaugruppe (3) zugewandten Außenseiten des Endstücks (5) hinaus auf ein entfernter angeordnetes Schaltelement eingegriffen werden kann.

5. Frontsystem nach einem der vorangegangenen Ansprüche, wobei das vom mechanischen Tastenelement (31,33) aktivierbare externe Schaltelement auf einer Außenseite des Endstücks (5) aufgesetzt ist und über eine an Anschlußkontakten anbringbare Kabel- oder Kabelsteckverbindung mit der Flachbaugruppe (3) elektrisch verbindbar ist.

6. Frontsystem nach einem der Ansprüche 1 bis 4, wobei das vom mechanischen Tastenelement (31,33) aktivierbare externe Schaltelement auf einer Oberseite der Flachbaugruppe (3) angebracht ist.

7. Frontsystem nach einem der vorangegangenen Ansprüche, wobei der Hebelziehgriff (19) bevorzugt auf dessen Oberseite ein vorstehendes Druckstück (35) aufweist, welches bei Annaherung des Hebelziehgriffes (19) an dessen fixierte Position auf das mechanische Tastenelement (31,33) eingreift.

8. Frontsystem nach Anspruch 7, wobei das Druckstück (35) mittig auf der Oberseite des Hebelziehgriffs (19) angeordnet ist und beidseitig von zwei Verrastfedern (25) mit nach oben stehenden Rastnasen flankiert wird (Fig.2).

## Claims

1. Front system of a printed circuit board assembly (3) which can be pushed into a mounting rack, having
a) one upper and one lower end piece (5) which are fitted in the upper and lower front corner region (1), respectively, of the printed circuit board assembly (3),
b) one upper and one lower lever pull handle (19), which are fitted to the upper and the lower end piece (5) respectively, for levering the printed circuit board assembly (3) into and out of the mounting rack, which lever pull handles (19) have means (25) via which the respective lever pull handle (19) is fixed in the appropriate position when the printed circuit board assembly (3) has reached the point where it has been pushed into the mounting rack, and having
c) a mechanical push-button element (31, 33) which is integrated in the upper or the lower end piece (5) which is acted on, via the appropriate lever pull handle (19), on reaching its fixed position in such a manner that an external, electrical switching element can be activated via the push-button element.

2. Front system according to Claim 1, spring means acting on the mechanical push-button element (31,33) in such a manner that the latter is held in a rest position, facing the lever pull handle (19), as long as the lever pull handle (19) is not located in the fixed position.

3. Front system according to Claim 1 or 2, the mechanical push-button element being designed in the form of a slide (31) which is guided in the end piece (5).

4. Front system according to one of the preceding claims, an extending contact bolt (33) being fitted to the mechanical push-button element, by means of which it is possible to act on a more remotely arranged switching element beyond one of the outer sides of the end piece (5) which face the printed circuit board assembly (3).

5. Front system according to one of the preceding claims, the external switching element, which can be activated by the mechanical push-button element (31,33), being placed on an outer side of the end piece (S) and it being possible for said external switching element to be electrically connected to the printed circuit board assembly (3) via a cable connection or cable plug connection which can be fitted to connecting contacts.

6. Front system according to one of Claims 1 to 4, the external switching element which can be activated by the mechanical push-button element (31,33) being fitted on an upper surface of the printed circuit board assembly (3).

7. Front system according to one of the preceding claims, the lever pull handle (19) preferably having a projecting thrust member (35) on its top, which thrust member (35) acts on the mechanical push-button element (31,33) as the lever pull handle (19) is approaching its fixed position.

8. Front system according to Claim 7, the thrust member (35) being arranged centrally on the top of the lever pull handle (19) and being flanked on both sides by two spring catches (25) with latching tabs pointing upwards (Fig. 2).

## Revendications

1. Système de panneau avant d'un module (3) plat, qui peut être enfilé dans un porte-module, comportant,
a) une pièce (5) d'extrémité supérieure et une pièce (5) d'extrémité inférieure montées respectivement dans la zone (1) d'angle avant supérieur et dans la zone (1) d'angle avant inférieur du module (3) plat,
b) une poignée (19) supérieure de traction formant levier et une poignée (19) inférieure de traction formant levier, montées respectivement sur la pièce (5) d'extrémité supérieure et sur la pièce (5) d'extrémité inférieure, pour faire entrer par effet de levier le module (3) plat dans le porte-module et pour l'en faire sortir par effet de levier, ces poignées comportant des moyens (25) par l'intermédiaire desquels la poignée (19) de traction formant levier associée est, lorsqu'est atteint l'état du module (3) plat dans lequel il est enfilé dans le porte-module, immobilisée en la position correspondante, et comportant
c) un élément (31, 33) mécanique formant touche, intégré à la pièce (5) d'extrémité supérieure ou à la pièce (5) d'extrémité inférieure, sur lequel il est agi par l'intermédiaire de la poignée (19) de traction formant levier correspondante lorsque sa position immobilisée est atteinte de telle manière qu'un élément de commutation électrique externe peut être activé par l'intermédiaire de l'élément formant touche.

2. Système de panneau frontal suivant la revendication 1, des moyens élastiques agissant sur l'élément (31, 33) mécanique formant touche de telle manière que cet élément est maintenu en une position de repos tournée vers la poignée (19) de traction formant levier, aussi longtemps que la poignée (19) de tirage formant levier ne se trouve pas en la position immobilisée.

3. Système de panneau avant suivant la revendication 1 ou 2, l'élément mécanique formant touche étant réalisé sous la forme d'un coulisseau (31) guidé dans la pièce (5) d'extrémité.

4. Système de panneau avant suivant l'une des revendications précédentes, une tige (33) de contact à rallonge étant montée sur l'élément mécanique formant touche, un élément de commutation, monté à distance pouvant être attaqué par cette tige au-delà de l'un des côtés extérieurs de la pièce (5) d'extrémité tournés vers le module (3) plat.

5. Système de panneau avant suivant l'une des revendications précédentes, l'élément de commutation externe pouvant être activé par l'élément (31, 33) mécanique formant touche reposant sur un côté extérieur de la pièce (5) d'extrémité et pouvant être relié du point de vue électrique au module (3) plat par l'intermédiaire d'une liaison par câble ou par enfichage de câbles pouvant être montée sur des contacts de raccordement.

6. Système de panneau avant suivant l'une des revendications 1 à 4, l'élément de commutation externe pouvant être activé par l'élément (31, 33) mécanique formant touche étant monté sur une face supérieure du module (3) plat.

7. Système de panneau avant suivant l'une des revendications précédentes, la poignée (19) de traction formant levier comportant, de préférence sur sa face supérieure, une pièce (35) en saillie pour faire pression, qui, lorsque la poignée (19) de traction formant levier s'approche de sa position immobilisée, attaque l'élément (31, 33) mécanique formant touche.

8. Système de panneau avant suivant la revendication 7, la pièce (35) de pression étant montée au milieu sur la face supérieure de la poignée (19) de traction formant levier et étant flanquée de part et d'autre de deux ressorts (25) d'encliquetage comportant des becs d'encliquetage en saillie vers le haut (figure 2).
